# DEMANDE DE BREVET EUROPEEN

(11) **EP 4 297 074 A1**
(43) Date de publication de la demande: **27.12.2023**
(21) Numéro de dépôt: 23179569.1
(22) Date de dépôt: 15.06.2023
(51) Int. Cl.: H01L 21/762, H01L 27/12, H01L 29/06, H01L 27/13, H01Q 1/22, H01Q 1/52, H01L 21/761

(54) **SUBSTRAT RF COMPRENANT DES RÉGIONS DE DÉSERTION INDUITES PAR EFFET DE CHAMP**

(30) Priorité: 21.06.2022 FR 2206090
(71) Demandeur: Commissariat à l'énergie atomique et aux énergies alternatives, 75015 Paris (FR); Université catholique de Louvain, 1348 Louvain-la-Neuve (BE)
(72) Inventeur: HUTIN, Louis, 38054 GRENOBLE CEDEX 09 (FR); MOULIN, Maxime, 38054 GRENOBLE CEDEX 09 (FR); FACHE, Thibaud, 38054 GRENOBLE CEDEX 09 (FR); PLANTIER, Christophe, 38054 GRENOBLE CEDEX 09 (FR); RASKIN, Jean-Pierre, 1348 Louvain-la-Neuve (BE); RACK, Martin, 1435 MONT-SAINT-GUIBERT (BE)
(74) Mandataire: Brevalex

(57) **Abrégé**

Structure pour dispositif RF munie d'un substrat doté d'une région semi-conductrice (12) revêtue d'une région diélectrique (20) hétérogène, la région diélectrique (20) hétérogène comportant, dans au moins une première direction parallèle à un plan principal du substrat, une alternance de premières zones en un premier matériau diélectrique (22) à charges fixes positives et de deuxièmes zones diélectriques en un deuxième matériau diélectrique (25) à charges fixes négatives afin de créer une alternance de polarité permettant d'empêcher la formation d'une couche de conduction parasite dans la région semi-conductrice.

## Description

### DOMAINE TECHNIQUE ET ART ANTERIEUR

La présente demande concerne le domaine de la microélectronique et en particulier celui des dispositifs destinés à des applications radiofréquences (RF).

Dans les dispositifs microélectroniques RF une couche de conduction parasite communément appelée « PSC » (pour « Parasitic Surface Conduction ») est susceptible de venir se créer dans une portion semi-conductrice agencée dans une partie supérieure d'un substrat.

Une amélioration connue des substrats pour les applications RF et en particulier des substrats de type semi-conducteur sur isolant consiste à former sous et contre une couche isolante du substrat communément appelée « BOX », une couche de piégeage encore appelée « trap rich ». Une telle couche est typiquement formée d'un matériau semi-conducteur riche en défauts cristallins et qui permet de piéger des charges.

La couche de piégeage peut être en particulier une couche de polysilicium réalisée à l'interface avec la couche isolante. Les porteurs libres attirés vers l'interface y sont piégés, et ne participent donc pas à la conduction parasite de surface. Avec une telle couche, on limite la conduction parasite à proximité de la couche isolante, et on améliore de cette manière les performances des circuits radiofréquences en termes d'isolation radiofréquence, de diminution des pertes d'insertion et d'intégrité du signal.

Une telle couche de piégeage est généralement obtenue via un procédé de fabrication appliqué sur toute l'étendue du substrat. Le document WO 2 005 031 842 A2 donne un exemple d'un tel procédé.

Une deuxième manière de limiter la circulation des courants parasites est proposée dans le document "Low-Loss Si-Substrates Enhanced Using Buried PN Junctions for RF Applications" de Rack et al., IEEE Electron Device Letters, 2019. Dans ce document, une alternance de bandes dopées de type N et de bandes dopées de type P est réalisée afin d'éviter la création d'une couche continue de type PSC.

Cette solution requiert la mise en oeuvre d'étapes d'implantation et en particulier l'utilisation de deux masques d'implantation dédiés, qui doivent de préférence être correctement alignés.

Une autre solution pour améliorer l'intégrité de signaux radiofréquence dans des substrats semi-conducteurs à haute résistivité est de mettre en oeuvre une polarisation spécifique par effet de champ en utilisant des pistes conductrices de contrôle dédiées. De telles pistes sont typiquement réalisées au même niveau que la ou les grilles de transistor ou bien dans le premier niveau métallique d'interconnexion communément appelé « métal 1 » (ou M1). Le document de Rack et al. "Field-Effect Passivation of Lossy Interfaces in High-Resistivity RF Silicon Substrates," 2021 Joint International EUROSOI Workshop and International Conférence on Ultimate intégration on Silicon (EuroSOI-ULIS), 2021 présente une telle méthode. Des zones de désertion sont créées à distance, grâce à un potentiel électrostatique appliqué sur ces pistes conductrices de contrôle. Cette solution nécessite l'introduction de pistes de conductrices de polarisation supplémentaires et d'utiliser un amplificateur de puissance pour acheminer un niveau de polarisation adéquat sur ces pistes.

Il se pose le problème de trouver une nouvelle structure qui permette d'empêcher ou de limiter la formation d'une couche PSC et ce sans devoir nécessairement faire à une électrode de polarisation spécifique et/ou devoir réaliser des implantations de dopants supplémentaires.

### EXPOSÉ DE L'INVENTION

Selon un mode de réalisation, on prévoit une structure pour dispositif RF munie d'un substrat doté d'une région semi-conductrice, la région semi-conductrice étant revêtue d'au moins une région diélectrique hétérogène, ladite région diélectrique hétérogène comportant, dans au moins une première direction donnée parallèle à un plan principal du substrat, une alternance de premières zones en un premier matériau diélectrique à charges fixes positives et de deuxièmes zones diélectriques en un deuxième matériau diélectrique à charges fixes négatives.

On prévoit ainsi en regard de la région semi-conductrice une alternance de matériaux diélectriques contenant des charges fixes dont le signe alterne également.

On crée ainsi par effet de champ une alternance de polarité qui agit au sein de la région semi-conductrice du substrat, ce sans avoir recours à un dopage ni à une utilisation de grilles ou pistes de contrôle spécifiques supplémentaires.

Avantageusement, lesdites première et deuxième zones diélectriques peuvent être réparties de manière périodique dans ladite première direction.

L'alternance de matériaux diélectriques à charges fixes positives et à charges fixes négatives peut être réalisée dans plusieurs directions parallèles au plan principal du substrat.

Ainsi, de manière avantageuse, dans au moins une deuxième direction réalisant un angle non-nul avec la première direction et parallèle à un plan principal de la couche isolante, la région diélectrique peut comporter une alternance de zones à base du premier matériau diélectrique et de zones diélectriques à base du deuxième matériau diélectrique.

Selon une possibilité de mise en oeuvre, les zones diélectriques à base du premier matériau diélectrique et à base du deuxième matériau diélectrique peuvent former un agencement en spirale ou en damier.

Avantageusement, le premier matériau diélectrique à charges fixes positives est choisi parmi les matériaux suivants : oxyde de silicium, nitrure de silicium, oxycarbure de silicium.

Avantageusement, le deuxième matériau diélectrique à charges fixes négatives est choisi parmi les matériaux suivants : alumine, oxyde d'hafnium.

Le substrat sur lequel la structure est formée peut être
- un substrat massif ou,
- un substrat de type semi-conducteur sur isolant, ladite région semi-conductrice étant une couche semi-conductrice superficielle ou une région d'une couche semi-conductrice superficielle disposée sur une couche isolante du substrat, ladite couche isolante étant agencée sur une couche de support semi-conductrice, ou
- un substrat hybride, ladite région semi-conductrice étant un ilot semi-conducteur agencé sur une première région d'une couche de support semi-conductrice du substrat hybride, la couche de support semi-conductrice comportant une deuxième région sur laquelle une couche isolante elle-même revêtue d'une couche semi-conductrice superficielle sont disposées.

Selon une possibilité de mise en oeuvre pour laquelle le substrat est de type semi-conducteur sur isolant, la couche de support semi-conductrice peut comporter une région de piégeage de charges, en particulier une région riche en défaut cristallins, telle qu'une couche de polysilicium.

Avantageusement, la région diélectrique hétérogène est agencée sur et en contact avec ladite région semi-conductrice.

Selon un autre aspect, la présente demande concerne un dispositif microélectronique comprenant :
- une structure telle que définie précédemment,
- un ou plusieurs composants électroniques, en particulier un ou plusieurs transistors au moins partiellement formés dans une région semi-conductrice dudit substrat
- au moins un composant RF tel qu'une antenne ou une inductance, ledit composant RF étant agencé en regard de la dite région diélectrique hétérogène.

### BRÈVE DESCRIPTION DES DESSINS

La présente invention sera mieux comprise sur la base de la description qui va suivre et des dessins en annexe sur lesquels :
La figure 1 illustre un agencement, pour permettre de limiter ou empêcher un phénomène de conduction parasite dans une couche semi-conductrice d'un dispositif RF, au moyen d'une région diélectrique hétérogène formée de zones de matériau diélectriques à charges fixes positives et de zones de matériau diélectriques à charges fixes négatives alternativement réparties.
La figure 2 illustre les performances d'une structure dudit agencement pour permettre de limiter ou empêcher la conduction parasite.
La figure 3 illustre un exemple de réalisation dans lequel la région diélectrique hétérogène est formée sur un substrat massif.
La figure 4 illustre un exemple de réalisation dans lequel la région diélectrique hétérogène est réalisée dans une technologie de type FD-SOI avec des zones hybrides.
La figure 5 illustre un exemple de réalisation dans lequel la région diélectrique hétérogène est formée sur un substrat de type semi-conducteur sur isolant.
La figure 6 illustre un exemple de réalisation dans lequel la région diélectrique hétérogène est associée à une couche de piégeage de charges.
La figure 7 illustre un exemple de réalisation particulier dans lequel la région diélectrique hétérogène est formée sur un ilot semi-conducteur agencé sur une région d'un substrat comportant également une autre région de type semi-conducteur sur isolant.
La figure 8 illustre une première variante de réalisation de la région diélectrique hétérogène.
La figure 9 illustre une deuxième variante de réalisation de la région diélectrique hétérogène.
La figure 10 illustre une troisième variante de réalisation de la région diélectrique hétérogène.
La figure 11 illustre une quatrième variante de réalisation de la région diélectrique hétérogène.
La figure 12 illustre une cinquième variante de réalisation de la région diélectrique hétérogène.

### EXPOSÉ DÉTAILLÉ DE MODES DE RÉALISATION PARTICULIERS

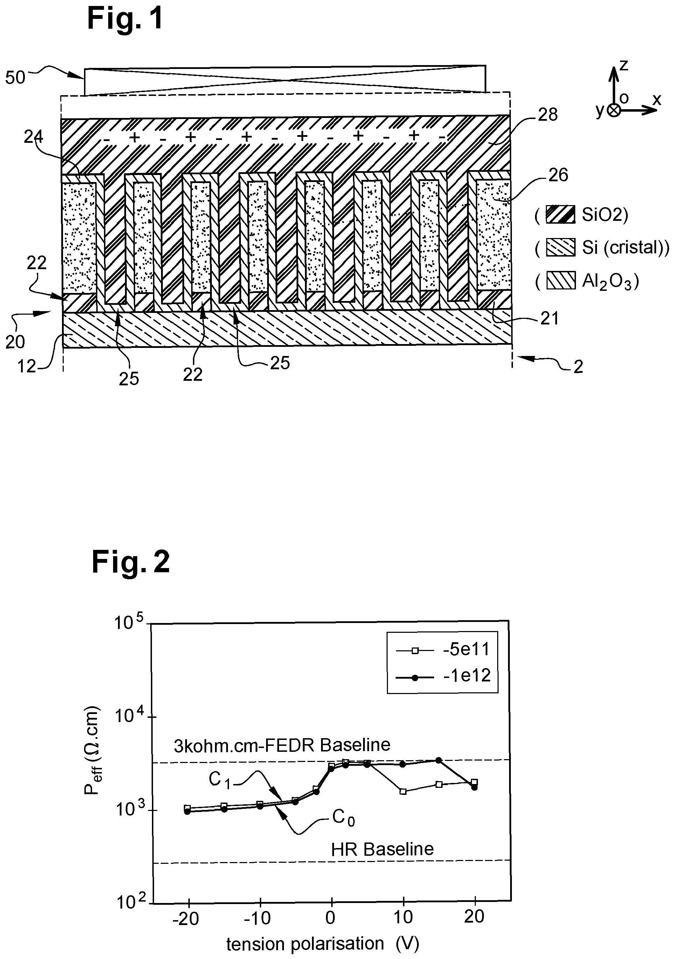

On se réfère à présent à la figure 1 donnant un exemple de structure pour dispositif RF comportant une région diélectrique 20 hétérogène dans laquelle une alternance de polarité est créée.

Les signaux RF visés sont typiquement ceux ayant une fréquence d'onde électromagnétique située entre 10 kHz et 100 GHz, avantageusement entre 1 MHz et 100 GHz et en particulier entre 1 MHz et 50 GHz.

La structure s'applique notamment à des dispositifs de communications spatiales et de télécommunications, par exemple aux dispositifs fonctionnant selon la technologie dite « 5G » qui désigne la cinquième génération des standards pour la téléphonie mobile.

La région diélectrique hétérogène 20 permet d'éviter une conduction parasite dans une couche semi-conductrice 12. Cette couche semi-conductrice 12 est ici une couche superficielle supérieure d'un substrat 2 semi-conducteur, par exemple un substrat massif (« bulk » selon la terminologie anglo-saxonne). Le substrat massif, par exemple en silicium, peut-être en particulier un substrat de résistivité élevé HR (HR pour « Haute Résistivité ») typiquement supérieure à 100 Ω.cm, et avantageusement supérieure à 1 kS2.cm

La région diélectrique 20 hétérogène est formée, dans au moins une première direction parallèle à un plan principal (i.e. un plan passant par le substrat 2 et qui est parallèle au plan [O;x;y] du repère [O ;x ;y ;z] sur la figure 1), d'une alternance de premières zones diélectriques à base d'un premier matériau diélectrique 22 et de deuxièmes zones diélectriques à base d'un deuxième matériau diélectrique 25. Le premier matériau diélectrique 22 et le deuxième matériau diélectrique 25 sont respectivement un matériau diélectrique à charges fixes positives et un matériau diélectrique à charges fixes négatives. Par matériau diélectrique à charges fixes positives on entend ici un matériau susceptible de comporter des charges fixes positives sans qu'une polarisation extérieure ne soit nécessaire. De même, par matériau diélectrique à charges fixes négatives on entend ici un matériau susceptible de comporter des charges fixes négatives sans qu'une polarisation extérieure ne soit nécessaire. Dans l'exemple de réalisation illustré les zones diélectriques de matériau diélectrique 22 à charges fixes positives et les zones diélectriques de matériau diélectrique 25 à charges fixes négatives sont en contact les unes des autres.

La répartition alternée de zones diélectriques à base d'un premier matériau diélectrique 22 et de deuxièmes zones diélectriques à base d'un deuxième matériau diélectrique 25 peut être réalisée dans plusieurs directions parallèles au plan principal du substrat, par exemple de sorte à former un motif en damier ou en spirale.

Le matériau diélectrique 22 à charges fixes positives est typiquement un matériau utilisé dans des étapes de procédé communément appelées de « back-end of line » (BEOL) autrement dit un ensemble d'étapes de fabrication d'un circuit allant d'un premier niveau de métallisation jusqu'au procédé de passivation du circuit. Le matériau diélectrique 22 peut être avantageusement choisi parmi les matériaux suivants : oxyde de silicium, en particulier du SiO₂, nitrure de silicium, oxycarbure de silicium.

Le deuxième matériau diélectrique 25, à charges fixes négatives, peut être, quant à lui, un matériau habituellement utilisé pour former certains diélectriques de grille. Le matériau diélectrique 25 peut être choisi parmi les matériaux suivants : alumine, en particulier de l'Al₂O₃ et oxyde d'hafnium, en particulier du HfO₂.

Un exemple de réalisation particulier prévoit une région diélectrique 20 hétérogène composée d'une alternance de zones en SiO₂ et de zones en Al₂O₃.

Les zones diélectriques à charges fixes négatives et les zones diélectriques à charges fixes positives sont de préférence réparties de manière périodique, selon un pas donné qui peut être compris entre plusieurs nanomètres et plusieurs micromètres, typiquement entre 100 nm et 10 µm, par exemple de l'ordre du micromètre.

Par cette alternance de matériaux 22, 25, on crée une alternance de polarité de charges afin de bloquer la circulation d'un courant parasite dans la couche semi-conductrice 12. Le blocage de conduction parasite est réalisé ici sans nécessairement avoir recours à un dopage spécifique ou devoir introduire des électrodes de polarisation spécifiques supplémentaires.

Dans la région diélectrique hétérogène 20, la valeur des densités de charges fixes positives et négatives en valeur absolue est typiquement comprise entre 10¹⁰ charges/cm² et 10¹³ charges/cm².

Dans le mode de réalisation particulier illustré sur la figure 1, la région diélectrique hétérogène 20 formée de l'alternance de zones diélectriques 22, 25 est agencée directement en contact avec la couche semi-conductrice 12 supérieure du substrat 2.

Il est en variante possible de prévoir la région diélectrique 20 à distance de la couche semi-conductrice 12, de préférence une distance proche, c'est-à-dire typiquement inférieure à 500 nm tout en pouvant maintenir l'effet de blocage de courant. La distance maximale entre les zones de diélectriques avec charges fixes positives et négatives et le substrat semiconducteur dépend avantageusement de la quantité de charges fixes dans les différentes zones de diélectriques. Plus cette quantité de charges fixes dans ces diélectriques est importante et plus ceux-ci peuvent être disposés à une distance importante du substrat semiconducteur. On conserve une capacité de modifier la concentration de charges mobiles dans le semiconducteur par effet de champ, et ainsi, forcer des zones riches en électrons sous les zones diélectriques avec des charges fixes positives et forcer des zones riches en trous sous les zones diélectriques avec des charges négatives.

Le blocage de courant réalisé par le biais de cette région diélectrique 20 formée d'une alternance de diélectriques 22, 25 différents peut être ici obtenu sans qu'une portion de la couche semi-conductrice 12 ou du substrat 2 située en regard de cette alternance ne comporte elle-même une alternance de zones dopées de types de conduction opposés P et N.

La répétition et le pas de répartition des zones de diélectriques 22, 25 permet de prévoir un composant RF ou circuit conducteur RF ou élément conducteur pour circuit RF (l'un ou l'autre de ces éléments étant représenté de manière schématique par un bloc référencé 50 sur la figure 1) en regard sans nécessairement devoir réaliser un alignement précis de ce composant ou de ce circuit ou de cet élément conducteur par rapport à la région diélectrique 20.

La région diélectrique 20 hétérogène peut s'étendre « pleine plaque », c'est-à-dire sur toute la surface du substrat 2.

En variante, la région diélectrique 20 peut être avantageusement localisée en dehors de zones où sont formés des transistors et de préférence uniquement sur une ou plusieurs zones agencées en regard de composant(s) ou de circuit(s) RF ou élément conducteur(s) pour circuit RF. Par exemple, lorsqu'elle est située en regard d'un guide d'ondes coplanaire ou d'une inductance, la région diélectrique 20 hétérogène peut s'étendre typiquement sur une distance de plusieurs dizaines de micromètres.

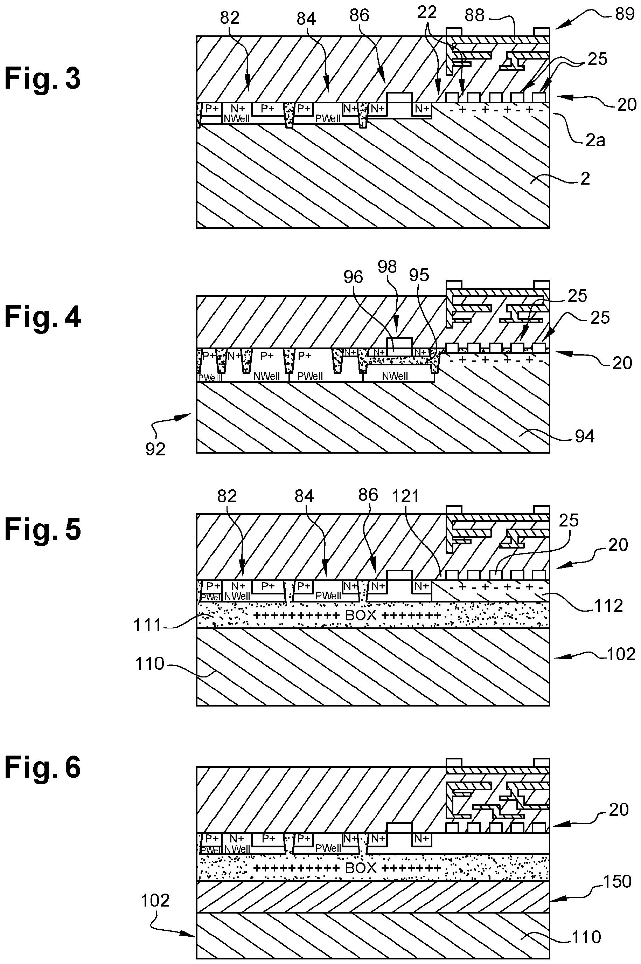

Un exemple de réalisation particulier de cette variante illustrée sur la figure 3 prévoit d'agencer la région diélectrique 20 hétérogène sur une région semi-conductrice 2a du substrat 2 massif qui est située en périphérie de parties dans lesquelles des transistors bipolaires 82, des diodes 84, et des transistors MOS 86 sont formés. La région diélectrique 20 à diélectriques 22, 25 de polarités opposées est située en regard d'un empilement de couches isolantes sur lequel sont formées des pistes conductrices 89, par exemple en Al, d'un composant RF et dans lequel des éléments d'interconnexion 88, par exemple en Cu sont agencés.

Dans une simulation effectuée à l'aide d'un outil du type TCAD (pour « Technology Computer Aided Design ») pour un diélectrique 22 à charges positives en SiO₂ et d'épaisseur de 1 µm, un diélectrique 25 à charges négatives en Al₂O₃ et d'épaisseur de 20 nm, un pas de répartition des zones diélectriques de 1 µm, on prévoit des charges fixes négatives imposées pour l'Al₂O₃ selon une densité comprise entre 5e11/cm² et 1e12/cm² et des charges fixes positives imposées pour le SiO₂ de l'ordre de 1e11/cm².

Sur la figure 2, les courbes C₀ et C₁ servent à illustrer des performances en termes de résistivité effective d'une structure telle que mise en oeuvre suivant l'invention, respectivement pour une concentration de charges fixes négatives respectivement de l'ordre de -1^{e}12 et de l'ordre de -5^{e}11, ce par rapport à un agencement conventionnel (« HR-Base line ») qui ne comporte pas d'alternance de régions diélectriques respectivement à charges fixes positives et à charges fixes négatives.

Selon une autre possibilité de mise en oeuvre, la région diélectrique 20 hétérogène formée de l'alternance de zones diélectriques 22, 25 peut être également réalisée sur un substrat de type semi-conducteur sur isolant, en particulier un substrat SOI (« Silicon On Insulator » ou « Silicium sur Isolant ») comportant une couche de support semi-conductrice revêtue d'une couche isolante typiquement appelée de « BOX », elle-même revêtue d'une couche semi-conductrice superficielle.

Ainsi, une telle structure peut être adaptée à la réalisation de circuits dans des technologies telles que le FD-SOI pour (« Fully Depleted Silicon On Insulator » ou SOI totalement déserté) ou le PD-SOI pour (« Partialy Depleted Silicon On Insulator » ou SOI partiellement déserté).

Un exemple de réalisation particulier de dispositif qui peut être réalisé en technologie FD-SOI est donné sur la figure 4. La région diélectrique 20 formée des zones de diélectrique à charges fixes positives et de zones de diélectrique à charge fixes négatives est localisée et ici juxtaposée à une zone dans laquelle un ou plusieurs transistors 98 sont formés sur une couche isolante 95, typiquement une couche d'oxyde de silicium, suffisamment épaisse, par exemple entre 10 et 200 nm, pour empêcher un couplage électrostatique en une couche de support semi-conductrice 94 d'un substrat 92 et une couche semi-conductrice superficielle 96 dans laquelle le transistor 98 est formé.

Un autre exemple de réalisation particulier en technologie de type PD-SOI est donné sur la figure 5. La région diélectrique 20 hétérogène formée des zones de matériaux diélectriques 22, 25, est cette fois agencée sur la couche semi-conductrice superficielle 112 semi-conductrice d'un substrat 102 semi-conducteur sur isolant dans laquelle des composants, en particulier des transistors bipolaires 82, des diodes 84, et des transistors MOS 86 sont formés. Le substrat 102, par exemple de type SOI, comporte une couche de support semi-conductrice 110, par exemple en silicium, une couche isolante 111, par exemple en oxyde de silicium, située entre la couche de support 110 semi-conductrice et la couche semi-conductrice superficielle 112 semi-conductrice, par exemple en silicium.

Selon une autre variante de réalisation, pour permettre de limiter ou éviter la conduction parasite de surface, on peut prévoir en combinaison avec la région diélectrique 20, une couche 150 de piégeage de charges dans la couche de support 110 du substrat 102. Ainsi dans l'exemple de réalisation illustré sur la figure 6, une couche de piégeages de charges par exemple en polysilicium s'étend en regard de la région diélectrique 20 à matériaux diélectriques de polarités opposées.

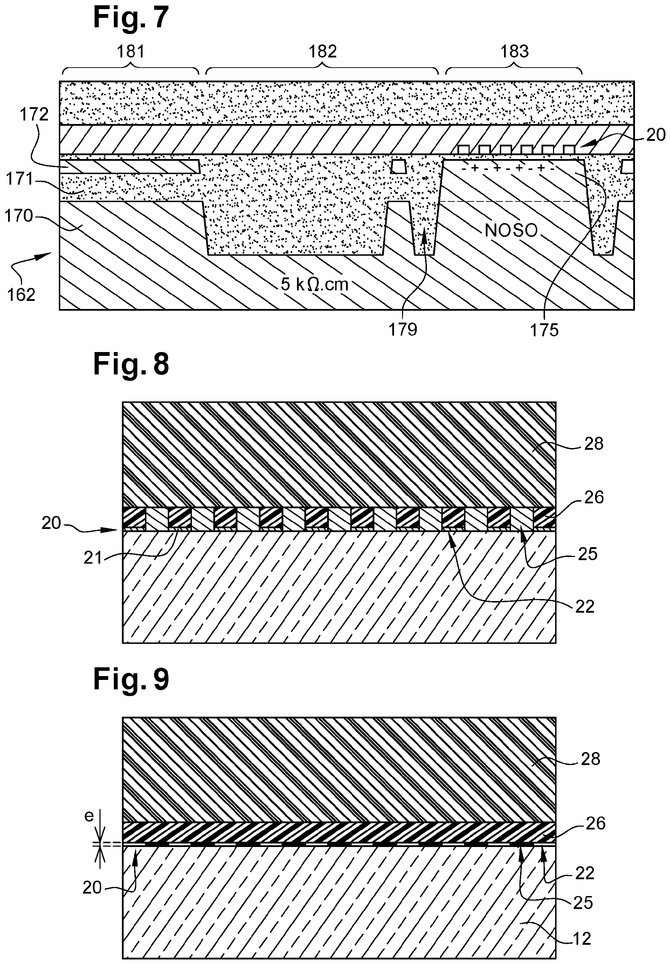

Un autre exemple de réalisation donné sur la figure 7 prévoit de former la région diélectrique 20 sur un ilot 175 semi-conducteur d'un substrat hybride 162.

Ce substrat 162 est ici doté d'au moins une première région 181 de type semi-conducteur sur isolant comportant une couche de support 170 semi-conductrice revêtue d'une couche isolante 171 de BOX elle-même revêtue d'une couche semi-conductrice 172 superficielle, tandis que l'ilot 175 semi-conducteur est situé dans une autre région 183 dans laquelle la couche semi-conductrice 172 superficielle n'est pas présentée et/ou a été retirée. L'ilot 175 semi-conducteur est typiquement en un matériau semi-conducteur de résistivité élevée, ou tout au moins plus élevée que celle de la couche semi-conductrice superficielle. Par exemple l'ilot peut être prévu avec une résistivité de l'ordre d'au moins cent fois la résistivité de la couche semi-conductrice superficielle.

Une telle autre région 183 appelée « NOSO » (pour « No SOI », autrement dit « sans SOI ») est ici séparée de la première région 181 dans laquelle des composants de type transistors sont prévus, par le biais d'une région 182 de séparation dans laquelle des tranchées isolantes 179 sont prévues.

Un procédé de réalisation d'une région diélectrique 20 hétérogène telle que décrite précédemment consiste à déposer tout d'abord une première couche 21 à base du matériau diélectrique 22, par exemple du SiOz, selon une épaisseur qui peut être par exemple comprise entre 1 et 30 nm, et avantageusement entre 5 nm et 25 nm et par exemple de l'ordre de 20 nm.

Puis, on forme une autre couche 26 isolante, qui peut être une couche d'arrêt de gravure de contact (CESL pour « Contact Etch Stop Layer »), par exemple en nitrure de silicium. Une telle couche 26 peut avoir une épaisseur de l'ordre d'une dizaine de nanomètres, par exemple comprise entre 5 et 40 nm et typiquement de l'ordre de 30 nm.

On réalise ensuite une pluralité d'ouvertures à travers la couche 26 d'arrêt de gravure, par exemple par gravure à travers un masquage formé par photolithographie. Un dépôt, en particulier de type conforme, d'une couche 24 à base du matériau diélectrique 25 à charges fixes négatives est ensuite réalisé. La couche 24, d'épaisseur par exemple de 20 nm, est ici déposée de sorte à tapisser le fond et les parois latérales des ouvertures. Ce dépôt peut être effectué de sorte qu'une partie centrale des ouvertures n'est pas comblée par le matériau diélectrique 25.

Plusieurs possibilités de réalisation peuvent être envisagées pour réaliser la gravure. Selon une première possibilité, on arrête cette gravure sur la couche 22 d'oxyde sous-jacente à l'autre couche 26 isolante de type CESL. Dans c cas, c'est alors cette couche 26 isolante de CESL qui joue le rôle de la couche chargée positivement. Dans un autre cas où l'on grave la couche 22 et l'on s'arrête sur le silicium, c'est la couche d'oxyde 22 qui joue le rôle de couche chargée positivement.

On effectue alors ensuite un remplissage des ouvertures au moyen d'une couche isolante 28. Cette couche 28 peut être une couche diélectrique pré-métallique (PMD) par exemple à base SiO₂.

Selon une variante de réalisation illustrée sur la figure 8, les ouvertures formées à travers l'empilement de la couche 21 à base de matériau diélectrique à charges fixes positives et de la couche 26 d'arrêt de gravure de contact, peuvent être entièrement comblées par le matériau diélectrique 25 à charges fixes négatives. On retire alors ensuite le matériau diélectrique 25 à charges fixes négatives en excédant dépassant au-dessus des ouvertures en réalisant une étape de planarisation CMP. Puis, on peut ensuite former la couche isolante 28 de type PMD.

Selon une autre variante, on peut prévoir de former les zones de matériau diélectrique 25 à charges fixes négatives après dépôt de la couche 26 d'arrêt de gravure de contact (CESL) et de la couche isolante 28. Les ouvertures réalisées à travers la couche 21 de matériau diélectrique à charges fixes positives sont alors ensuite pratiquées à travers un empilement comprenant la couche 21 à base de matériau diélectrique à charges fixes positives, la couche 26 d'arrêt de gravure de contact, la couche de matériau isolant 28. On remplit ensuite comme sur la figure 5, ces ouvertures pour former les zones de matériau diélectrique 25 à charges fixes négatives.

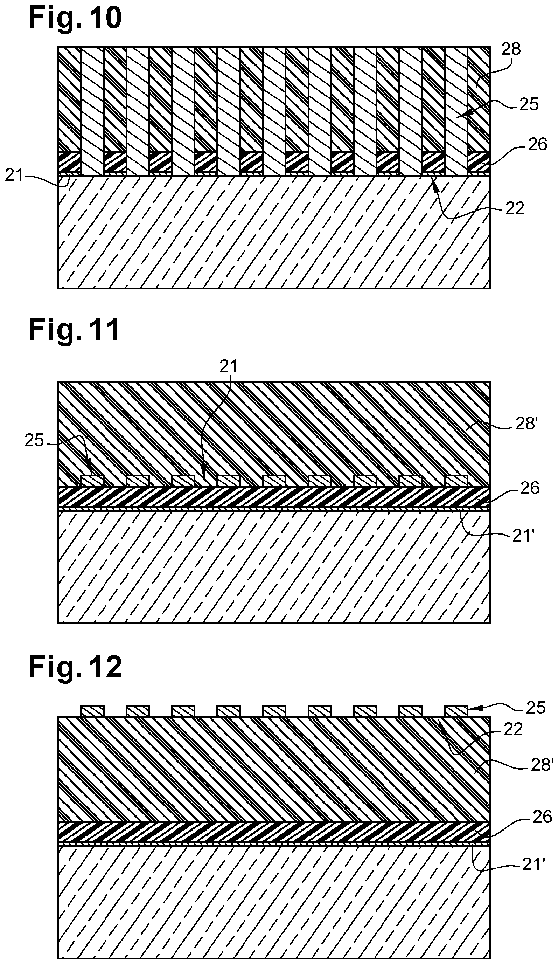

Comme indiqué précédemment, et comme illustré sur la figure 11, les zones de matériau diélectrique 25 à charges fixes négatives et les zones de matériau diélectrique 22 à charges fixes positives peuvent être agencées à distance de la couche semi-conductrice 12. Les zones de matériau diélectrique à charges fixes négatives et les zones de matériau diélectrique à charges fixes négatives sont alors typiquement réalisées après la couche 26 d'arrêt de gravure.

Ainsi, on peut tout d'abord former une couche 21' isolante, par exemple en TeOS. Puis, on dépose la couche 26 d'arrêt de gravure par exemple en nitrure.

Ensuite, on forme les zones diélectriques à base de matériau diélectrique à charges fixes négatives et des zones diélectriques à base de matériau diélectrique à charges fixes positives.

Les zones diélectriques à base de matériau diélectrique 25 à charges fixes négatives peuvent être réalisées par dépôt dans laquelle on réalise des motifs par photolithographie. Une couche d'Al₂O₃ d'épaisseur qui peut être par exemple de l'ordre de 20 nm peut-être pour cela formée.

Les zones diélectriques à base de matériau diélectrique à charges fixes positives peuvent être ensuite formées par dépôt d'une autre couche isolante 28', par exemple une couche de type PMD en SiOz, comblant des espaces entre les motifs de matériau diélectrique à charges fixes négatives et recouvrant ces motifs. Cette autre couche isolante 28' est réalisée par exemple par PECVD.

Une telle variante permet de limiter le nombre de couches gravées et en particulier d'avoir à graver des couches en des matériaux différents.

Selon une autre variante illustrée sur la figure 12, les zones diélectriques à base de matériau diélectrique 25 à charges fixes négatives sont formées après les zones diélectriques à base de matériau diélectrique 22 à charges fixes négatives.

Plus généralement, l'ordre des étapes de réalisation des zones diélectriques à base de matériau diélectrique 25 à charges fixes négatives et des zones diélectriques à base de matériau diélectrique 22 à charges fixes négatives peut être inversé.

## Revendications

1. Dispositif microélectronique comprenant :
- une structure pour dispositif RF munie d'un substrat (2, 92, 102, 162), le substrat étant doté d'une région semi-conductrice (2a, 12, 112, 175) revêtue d'au moins une région diélectrique (20) hétérogène, ladite région diélectrique (20) hétérogène comportant, dans au moins une première direction (d1) donnée parallèle à un plan principal du substrat, une alternance de premières zones en un premier matériau diélectrique (22) à charges fixes positives et de deuxièmes zones diélectriques en un deuxième matériau diélectrique (25) à charges fixes négatives.
- un ou plusieurs composants électroniques, en particulier un ou plusieurs transistors au moins partiellement formés dans une région semi-conductrice dudit substrat (2, 92, 102, 162)
- au moins un composant RF tel qu'une antenne ou une inductance ou un guide d'onde, ledit composant RF étant agencé en regard de la dite région diélectrique (20) hétérogène.

2. Dispositif selon la revendication 1, lesdites première et deuxième zones diélectriques étant réparties de manière périodique dans ladite première direction.

3. Dispositif selon l'une des revendications 1 ou 2, dans lequel ladite région diélectrique (20) comporte dans au moins une deuxième direction réalisant un angle non-nul avec la première direction et parallèle à un plan principal de la couche isolante, une alternance de zones à base du premier matériau diélectrique (22) et de zones diélectriques à base du deuxième matériau diélectrique (25).

4. Dispositif selon l'une des revendications 1 à 3, dans lequel le premier matériau diélectrique (22) à charges fixes positive est choisi parmi les matériaux suivants :
oxyde de silicium, nitrure de silicium, oxycarbure de silicium.

5. Dispositif selon l'une des revendications 1 à 4, dans lequel le deuxième matériau diélectrique (25) à charges fixes négatives est choisi parmi les matériaux suivants :
alumine, oxyde d'hafnium.

6. Dispositif selon l'une des revendications 1 à 5, dans lequel ledit substrat est :
- un substrat massif (2) semi-conducteur ou,
- un substrat (102) de type semi-conducteur sur isolant, ladite région semi-conductrice (12) étant une couche semi-conductrice superficielle (112) disposée sur une couche isolante (111) du substrat, ladite couche isolante (111) étant agencée sur une couche de support (110) semi-conductrice du substrat, ou
- un substrat (162) hybride, ladite région semi-conductrice étant un ilot (175) semi-conducteur agencé sur une première région d'une couche de support (170) semi-conductrice du substrat hybride, la couche de support (170) semi-conductrice comportant une deuxième région sur laquelle une couche isolante (171) elle-même revêtue d'une couche semi-conductrice superficielle (172) sont disposées.

7. Dispositif selon la revendication 6, dans lequel le substrat (102) est de type semi-conducteur sur isolant et dans lequel la couche de support semi-conductrice comporte une région (150) de piégeage de charges, en particulier une région riche en défaut cristallins, telle qu'une couche de polysilicium.

8. Dispositif selon l'une des revendications 1 à 7, dans lequel la région diélectrique (20) est agencée sur et en contact avec ladite région semi-conductrice (2a, 12, 112, 75).

9. Dispositif selon l'une des revendications 1 à 8, dans lequel les première zones diélectriques de matériau diélectrique (22) à charges fixes positives et les zones diélectriques de matériau diélectrique (25) à charges fixes négatives sont en contact les unes des autres.
